Europäisches Patentamt

European Patent Office

Office européen des brevets

(19)

(11) Publication number: **0 042 924**
**B1**

(12) **EUROPEAN PATENT SPECIFICATION**

(45) Date of publication of patent specification: **21.03.84**

(51) Int. Cl.³: **G 06 F 1/04, H 03 L 7/18**

(21) Application number: **81102943.8**

(22) Date of filing: **16.04.81**

(54) Data transfer apparatus.

(30) Priority: **30.06.80 US 184380**

(43) Date of publication of application:
**06.01.82 Bulletin 82/1**

(45) Publication of the grant of the patent:
**21.03.84 Bulletin 84/12**

(84) Designated Contracting States:
**DE FR GB IT**

(56) References cited:
**US - A - 3 217 267**
**US - A - 3 740 590**

**IBM TECHNICAL DISCLOSURE BULLETIN, vol.
17, no. 7, December 1974, New York, US DUKE:
"Multiple frequency clocking system", pages
2046-2049**
**IBM TECHNICAL DISCLOSURE BULLETIN, vol.
10, no. 11, April 1968 New York, US TSUI: "Use
of derived timing pulses in I/O devices", page
1808**

(73) Proprietor: **International Business Machines
Corporation**
**Old Orchard Road**
**Armonk, N.Y. 10504 (US)**

(72) Inventor: **Flemming, Donald Clyde**
**Mountain View Road**
**Rhinebeck New York 12572 (US)**

(74) Representative: **Lancaster, James Donald**
**IBM United Kingdom Patent Operations Hursley
Park**
**Winchester, Hants, SO21 2JN (GB)**

(56) References cited:
**NEC RESEARCH & DEVELOPMENT, no. 53, April
1979, Tokyo, JP KUSAMA et al. "Tunable phase-
locked oscillator with digital frequency divider"
pages 56-61**
**ELEKTRONIK, vol. 25, no. 9, September 1976
Munich, DE DIRKS et al. "Taktgenerator für
Mikroprozessor 6800" page 71**

Courier Press, Leamington Spa, England.

Data transfer apparatus

Introduction

The present invention relates to the transfer of data across an interface between parts of associated apparatus with dissimilar non-harmonic clocking rates. For example the parts can be parts of a computer system linked by latches on either side of the interface, and the invention can avoid metastability in the latches.

Background of the invention

An error condition may exist at the interface of two systems each of synchronous logic but with dissimilar and asynchronous clocking rates because of what is commonly referred to as the metastable latch problem. In a bistable latch where the coincidental occurrence of two pulses is required to change the state of the latch, an anomalous failure mode may occur when the two actuating pulses do not overlap sufficiently to cause the latch to completely switch from one of its stable states to the other. With such insufficient overlap of the two actuating pulses, the output or outputs of the latch do not go to either one of the stable up or down levels but actually perturbate at or around a third level referred to as the metastable level. The metastable level is exactly half way between the up and down levels, and when metastability occurs, the latch outputs either momentarily sit at the metastable level before randomly changing to a stable up or down level or alternatively they oscillate around this metastable level.

In latches actuated by signals from two different logic systems running under different and asynchronous clocking rates, the metastable latch problem arises because the clock pulse of one of the systems overlaps, captures or samples an insufficient portion of the data signal from the other system. It is particularly diffiuclt to correct metastability in the transfer of data between two asynchronous systems because the phase of the data signals of each of the two systems is continuously changing with respect to the clock pusles of the other system.

As far as it is caused by differences in clocking rates the metastable latch problem can be solved with known techniques, by running both interfacing systems, from a single clock or two synchronised clocks, at the same clocking rate or at harmonically related clocking rates. However, using the same clocking rate or a harmonic relationship between the two clocking rates is not always a practical solution in any given situation, since it may not allow either system to run anywhere near its optimum operating rate. What is needed is a relationship between the two clocking rates that would allow each of the interfacing systems to approach its maximum performance level while providing the reliable data transfer across the interface.

The solution according to the invention is given in claim 1.

Preferably the clocks are synchronised by phase lock loop circuitry. Phase-locked oscillators are known (e.g. see examples cited in the European Search Report, US—A—3,217,276, and NEC Research and Development No. 53, April 1979, Tokyo, J. P. Kusama et al. "Tunable phase-locked oscillator with digital frequency divider" pages 56—61).

Figure 1 is a block diagram of a simple latch along with diagrams on input and output pulses of the latch which illustrate the metastable condition.

Figure 2 is a graph illustrating the relationship between a system clock and a subsystem clock in an nonsynchronously operated computer system.

Figure 3 is a graph showing the hatched square in Figure 2 in greater detail to illustrate the manner in which nonsynchronous clock rates are selected in accordance with the present invention.

Figures 4a to 4c show pulse synchronous and associated waveforms showing desirable mutual properties of the clocks obtained by selecting the clocks in accordance with the present invention.

Figure 5 is a schematic diagram computer system using the clocking scheme of the present invention, and

Figure 6 is a block diagram of the phase lock loop system for generating two clocks in accordance with the present invention.

Detailed description

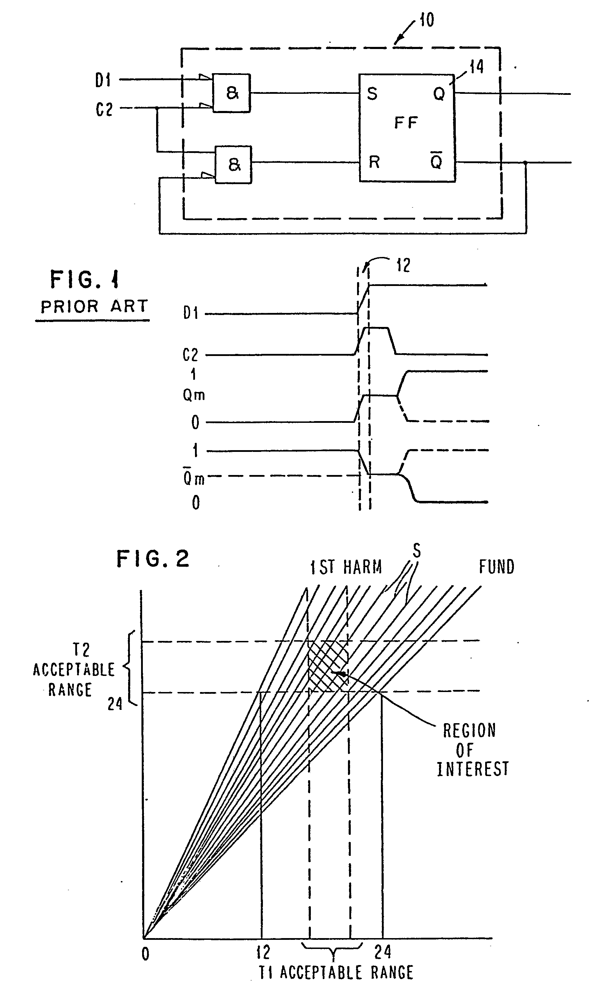

Referring to Figure 1, the metastable latch condition occurs in the latch 10 when two pulses $D_1$ and $C_2$, whose coincidental occurrence is necessary for the setting of the state of the latch 10, do not occur with sufficient overlap 12 for the flip flop 14 of the latch to fully switch from one state to another. This causes the latch 10 to drop into what is referred to as the metastable state. In the metastable state, the outputs Q and $\overline{Q}$ of the latch are neither at a stable up (1) or down (0) level but instead both are at a third level half way between the 0 and 1 levels.

This third level is undecipherable by the other circuits in the system causing an error condition to exist.

As can be seen, when the system clock $C_2$ is rising just as a data signal $D_1$ rises, an insufficient amount of the data signal $D_1$ is sampled during the clock pulse $C_2$ to properly activate the flip flop 14. The flip flop 14 being confused by the signals momentarily drops into the metastable state causing both outputs of the latch to go to a level m half way between the up and down levels of the flip flop. Eventually, the flip flop 14 randomly assumes one of its two stable states which may or may not be the correct stable state. The phasing of the two input pulses, illustrated in Figure 1, can arise for a number of reasons. However, the reason we are concerned with here is the constant changing in the phase between the two pulses $C_2$ and $D_1$, which occurs when these pulses are from different systems of synchronous logic with dissimilar and asynchronous clocking rates.

One way of eliminating this cause of metastability, with known techniques, involves making the clocking rates of the two systems the same and providing them from a single pulse source or from two synchronized sources. Another approach is to operate one clock at a harmonic frequency of the other and again supply them from a single source or two synchronized sources. However, either of these approaches may not be the best solution in a particular situation.

The problem with always using the same or harmonically related clocks can be better understood by reference to Figure 2 where the numbers along the ordinate represent possible subsystem clock periods $T_2$, while the numbers along the abscissa represent possible system periods $T_1$. Assume now that in the system under discussion, the most efficient and fastest operation of subsystems is with the period of the subsystem clock set at about 24 nanoseconds, while the most efficient and fastest operation of the system is with the period of the system clock set at about 19 nanoseconds. With these constraints, it is obvious that we can run the system clock at 24 nanoseconds, or in other words the same speed as the subsystem clock, but we could not run the system clock at 12 nanoseconds which would be the first harmonic of the subsystem clock. However, it is possible with the techniques of the present invention to operate the system clock with a period shorter than 24 nanoseconds and longer than 12 nanoseconds without incurring metastability caused by asynchronous operation of the two clocks $T_1$ and $T_2$.

The hatched out area in Figure 2 defines the concurrence of the acceptable ranges of operation of the two clocks. In accordance with the present invention, the operating periods of the two clocks is selected to be within this region of concurrence along one of the lines S radiating out from the zero point on the graph between the fundamental and first harmonic lines. These radiating lines have a slope,

$$S = \frac{T_2}{\alpha} \bigg/ \frac{T_1}{\alpha}$$

where S is a rational number (i.e., $T_2/\alpha$ and $T_1/\alpha$ are integers) with

$$\alpha = \frac{|T_2 - T_1|}{|s_n - s_d|}$$

and

$$S = \frac{s_n}{s_d}.$$

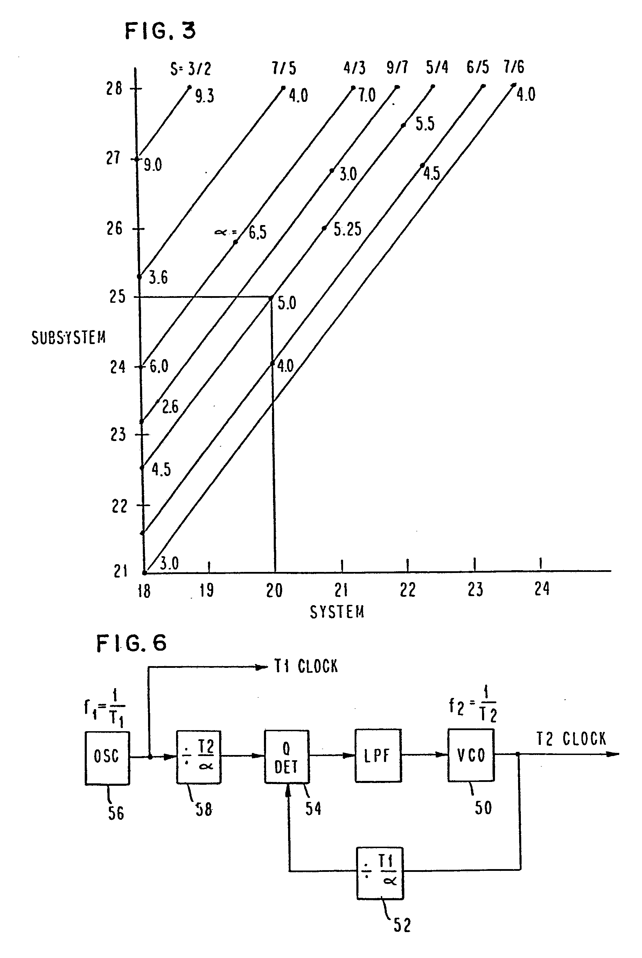

Figure 3 shows the hatched area in Figure 2 in more detail with the ratio $T_2/T_1$ shown at the top of each radiating line S and various values of $\alpha$ indicated, along each line S. While S is a rational number, there are only a finite number of different pulse phase relationships between $C_1$ and $C_2$ before the relationships repeat themselves. In effect, two pulse trains represented by $C_1$ and $C_2$ precess at the rate of $\alpha$ time units per cycle. For any two periods $T_1$ and $T_2$ with an S which is a rational number, the number of such phase relationships, relative to the clock period of interest, $T_n$, is equal to $T_n/\alpha$. As an example, assume that the period of the channel clock is set to be 25 nanoseconds, then in accordance with the present invention, the period of the processor clock is selected from the graph of Figure 3 to be 20 nanoseconds. By definition, $\alpha$ then would be 5.

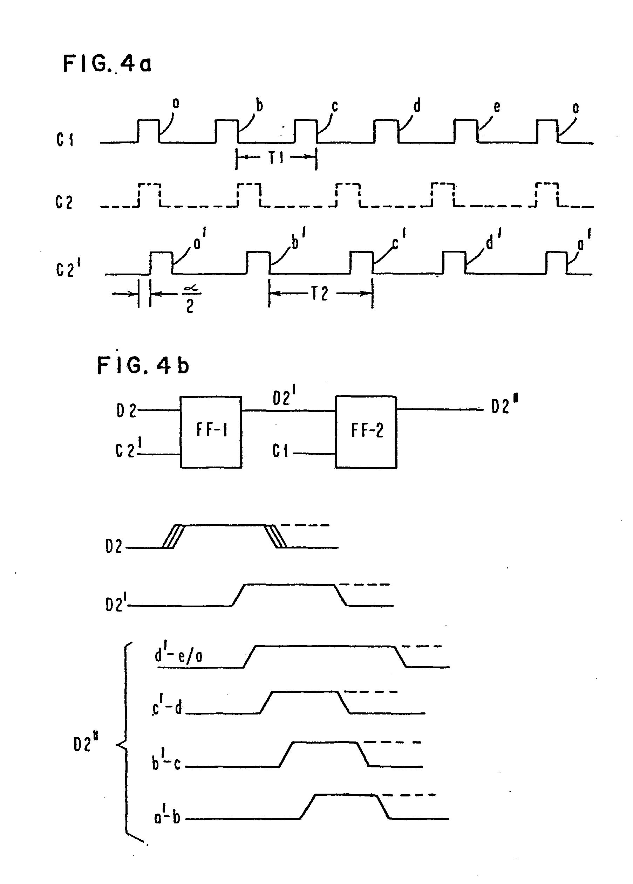

As shown in Figure 4a, there are only four possible different transition positions of $C_2$ during any period of the clock $C_1$. Similarly, there are only five possible different positions in which the leading edge transition of clock $C_1$ can occur during any period of clock $C_2$. These positions occur at 5 nanosecond intervals meaning that there are 5 nanosecond intervals, or "windows" in which the leading edge transition of one clock pulse will never occur during any given period of the other clock. By delaying one clock by $\alpha/2$ time units with respect to the other, we can move these intervals or windowss so they will occur at the time of a critical transition.

$C_2'$ is the waveform for $C_2$, delayed by $\alpha/2 = 2.5$ nanoseconds, such that alignment of the two clock critical (in this case, trailing) edges is avoided for all pulse pair combinations. The relationship between clock pulse sequences repeats every, $T_2/\alpha = 5$ pulses of $C_1$ or $T_1/\alpha = 4$ pulses of $C_2'$ and precession between the pulse trains is at the rate of $\alpha = 5$ nanoseconds per cycle.

In Figure 4b, two closely coupled master-slave flip flops, FF-1 and FF-2, are used to transfer data signals ($D_2$) from a system clocked by $C_2'$ to a system clocked by $C_1$. The flip flops FF1 and FF-2 are of the type shown in Figure 9.21 and described beginning on page 233 of a book entitled "Introduction to Switching Theory & Logical Design", Second Edition, by Fredrick J. Hill and Gerald R. Peterson, published by John Wiley & Son, New York in 1974. These flip-flops are designed for trailing edge actuation between master and slave sections. Edge actuation flip flops such as the master slave flip flop are used to avoid metastability problems with other combinations of critical edges than those aligned in accordance with the present invention. Signal $D_2$ may arrive at FF-1 anytime during a $C_2'$ cycle and may persist for one or more of the $C_2'$ cycles. At the output of FF-1, $D_2$ has been retimed to one of the critical edges of $C_2'$ (a', b', etc...) such that transitions of $D_2'$ are not coincident with critical edges of $C_1$ (a, b, etc...). Thus, after $D_2'$ retimed in FF-2 by $C_1$, $D_2''$ is generated at one of the times shown depending on which $C_1$ pulse samples $D_2'$. In the case where $C_1$ edge 'e' performs the sampling, edge 'a' will resample the same $D_2'$ signal one $C_1$ cycle later, resulting in the two cycle minimum output pulse shown. Transfers conducted by all other combinations of edge pairs will result in one cycle minimum pulses out, as shown.

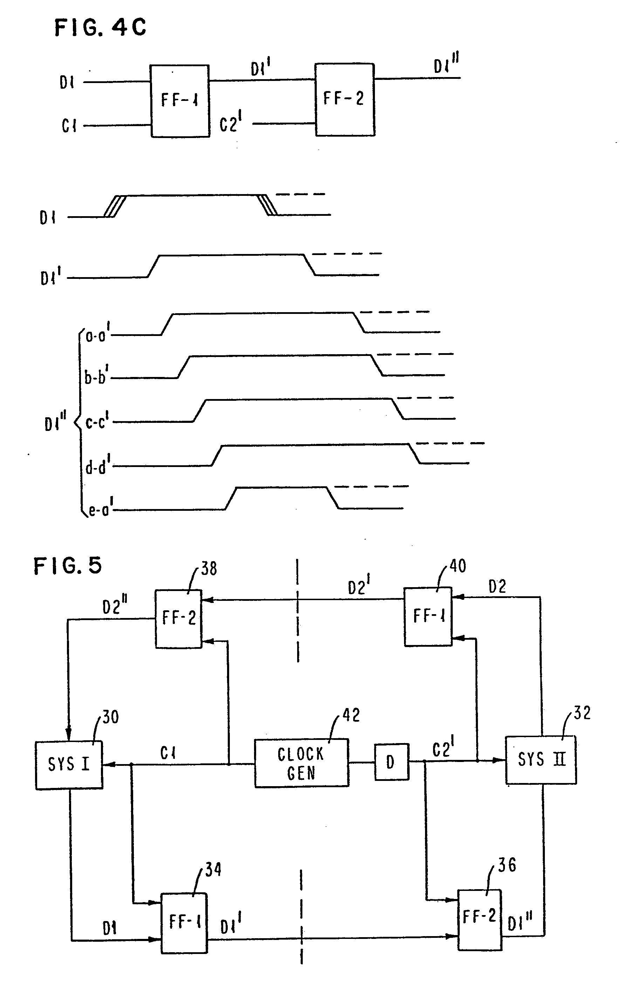

Figure 4(c) shows corresponding relationships for transfers from a system clocked by $C_1$ to a system clocked by $C_2'$. Since $C_2'$ has a longer period than $C_1$, oversampling of $D_1'$ is not possible, but undersampling would occur if a one cycle $D_1'$ pulse were to arrive between $C_1$ edges 'e' and 'a'. To prevent missing this event, all $D_1$ pulses must have a minimum width of two cycles. Then $D_1''$ will be two cycles minimum duration except for an input pulse rising with edge 'e'. This will not be sampled by $C_2'$ until edge 'a' arrives, resulting in the one cycle output pulse shown.

In Figure 5, a synchronizer is shown for transferring clocked data bits back and forth between the processor 30 and the channel 32 one bit at a time. The synchronizer is formed of the two sequences of the type discussed in connection with Figure 4 in each direction making a total of four clocked master slave flip flops 34 to 40. Each of these flip flops receives a data signal from one or the other of the systems, and a clock pulse from a clock generator 42, which will be described hereinafter. Transmission delays of various amounts are involved in the transmission of the clock pulses and the data registers. These delays must be taken into account to avoid metastability due to these delays. However, some compensation on such delays is well known in the prior art. They are disregarded here for simplicity and understanding of the present invention.

Assume we have the situation described in Figure 1, where the data signal $D_1$ is being transmitted from system 1 or the processor to system 2 or the channel. Then the data signal is fed into a first latch 34 along with the clock $C_1$ to set the latch 34 and the clock $C_1$ is used to reset the latch. The trailing edge of the output pulse $D_1'$ of latch 34 is therefore fixed to coincide with the trailing edge of the clock pulse $C_1$. The output pulse $D_1'$ is fed to the input of latch 36 along with the clock $C_2'$, where the phasing at the inputs is set to be as previously described and shown in Figure 4 by the relationship between curves $D_1$ and $C_2'$.

In the real systems of course, the window would not actually be a full 5 nanoseconds. Consideration must be given to deviations in the occurrences of the pulses from system to system because of manufacturing tolerances and within each system depending on design and implementation options.

The clock generator 42 in Figure 5 is shown in more detail in Figure 6. As can be seen, it contains a phase lock loop. The function of the phase lock loop is to provide a phase and frequency relationship between clock pulses $C_1$ and $C_2$ for the processor and channel systems respectively. The phase lock loop consists of four basic components, the voltage controlled oscillator 50, the frequency divider 52, phase frequency comparator 54 and a low pass filter. The input to the phase lock loop is from an oscillator 56 which generates the clock signal $C_1$ for the processor. The frequency of oscillation of the oscillator is set at

$$F_1 = \frac{1}{T_1}.$$

The output of the oscillator is divided by $T_2/\alpha$ in divider 58 before being fed to the phase/frequency comparator 54. The frequency phase comparator 54 compares the output of divider circuit 58 with the output of divider circuit 52 which divides the output of the voltage controlled oscillator 50 by $T_1/\alpha$. This is to determine if the voltage controlled oscillator 50 is tracking the oscillator 56. This is done by comparing the positive transition of circuit 58 to the positive transition of the frequency divider 52. If the reference is early, the output of the comparator 54 switches to a down level. If the reference is late, the output goes to a high level. The filter smoothes out the comparator output so that the output frequency of the voltage controlled oscillator only follows long term changes in the reference signal phase. The output of the voltage controlled oscillator is the channel clock $C_2$.

Above, we have described one embodiment of the invention. In this embodiment, the two periods $T_1$ and $T_2$ were fairly arbitrarily selected. However, in real applications, other considerations could put constraints on the values that can be selected.

Generation of the time of day clock requires that the value of the system clock $C_1$ be set at specific values, one of which may or may not be 20 nanoseconds. In any case, it is quite easy to change the system clock $C_1$ from 20 nanoseconds to say 20.94 nanoseconds as required by the time of day clock, and then select a channel clock of 26.18 nanoseconds instead of 25 nanoseconds and still obtain full advantage of the present invention. Therefore, it should be understood that while a single embodiment of the invention has been described, many changes in this embodiment can be made without departing from the spirit and scope of the invention, as set forth in the claims attached hereto.

**Claims**

1. Data transfer apparatus in which data is transferred across an interface in each direction between a first and a second system, the apparatus containing a clock generator for providing two non-harmonic but synchronised clock signals $C_1$ and $C_2$, the clock signals having periods of $T_1$ and $T_2$ time units forming a rational number ratio

$$S = \frac{T_2/\alpha}{T_1/\alpha},$$

so that the relationship between the clock pulse sequences repeats every $N_1 = T_2/\alpha$ pulses of $C_1$ or $N_2 = T_1/\alpha$ pulses of $C_2$, which gives

$$\alpha = T_2/N_1 = T_1/N_2,$$

the data transfer being under the control of the clock signal $C_1$ and a clock signal $C_2'$, each clock signal $C_1$ and $C_2'$ also being provided to the respective system, whereby alignment of the critical clock pulse edges of the clock signals $C_1$ and $C_2$ is avoided for all pulse pair combinations by delaying clock signal $C_2$ by an amount of $\alpha/2$ time units for forming clock signal $C_2'$, the data transfer being carried out in such a way that for each direction of data flow across the interface data supplied by a system is first sampled by the clock provided to that system and then sampled by the clock provided to the other system.

2. Apparatus as claimed in claim 1 in which the clock generator comprises a first oscillator (56) and a second voltage controlled oscillator (50) operating respectively at $f_1 = 1/T_1$ and $f_2 = 1/T_2$, the second oscillator being synchronised with the first by phase lock loop circuitry (Fig. 6).

3. Apparatus as claimed in claim 2 in which the clock generator is offset by delay circuitry (D. Fig. 5) connected to the output of the second oscillator.

4. Apparatus as claimed in any preceding claim in which a pair of latches (38, 40; 34, 36) is provided for each direction of data flow across the interface, each latch of a pair receiving a respective one of the clocks ($C_1$, $C_2'$).

**Revendications**

1. Appareil de transfert de données, dans lequel les données sont transférées par l'intermédiare d'un interface dans chaque sens entre un premier et un second système, l'appareil contenant un générateur de signaux d'horloge destiné à fournir deux signaux d'horloge $C_1$ et $C_2$ non harmoniques mais synchronisés, les signaux d'horloge possédant des périodes égales à $T_1$ et $T_2$ unités de temps formant un rapport

$$S = \frac{T_2/\alpha}{T_1/\alpha}$$

qui est un nombre rationnel de sorte que la relation entre les séquences des impulsions d'horloge se répète toutes les $N_1 = T_2/\alpha$ impulsions de $C_1$ ou $N_2 = T_1/\alpha$ impulsions de $C_2$, ce qui donne

$$\alpha = T_2/N_1 = T_1/N_2,$$

le transfert des données étant réalisé sous la commande du signal d'horloge $C_1$ et d'un signal d'horloge $C_2'$, chaque signal d'horloge $C_1$ et $C_2'$ étant également envoyé au système respectif, ce qui a pour effet que l'alignement des flancs critiques des impulsions d'horloge des signaux d'horloge $C_1$ et $C_2$ est évité pour toutes les combinaisons paires d'impulsions en retardant d'une quantité égal à $\alpha/2$ unités de temps, le signal d'horloge $C_2$ pour former le signal d'horloge $C_2'$, le transfert des données étant effectué de telle manière que, pour chaque sens de circulation des données à travers l'interface, les données envoyées par un système soient tout d'abord échantillonnées par le signal d'horloge envoyé à ce système, puis soient échantillonnées par le signal d'horloge envoyé à l'autre système.

2. Appareil selon la revendication 1, dans lequel le générateur de signaux d'horloge comporte un premier oscillateur (56) et un second oscillateur (50) commandé par une tension, fonctionnant respectivement à $f_1 = 1/T_1$ et $f_2 = 1/T_2$ le second oscillateur étant synchronisé sur le premier au moyen d'un circuit à boucle de verrouillage de phase (Figure 6).

3. Appareil suivant la revendication 2, dans lequel le générateur de signaux d'horloge est soumis au décalage d'un circuit à retard (D. Figure 5) raccordé à la sortie du second oscillateur.

4. Appareil selon l'une quelconque des revendications précédentes, dans lequel un couple de registres à verrouillage (38, 40, 34, 36) est prévu pour chaque sens de circulation des données à travers l'interface, chaque registre à verrouillage d'un couple recevant l'un des signaux d'horloge ($C_1$, $C_2'$).

**Patentansprüche**

1. Datenübertragungseinrichtung, bei der Daten über ein Interface in jede Richtung zwischen einem ersten und einem zweiten System übertragen werden, wobei die Einrichtung einen Taktgenerator, zur Erzeugung zweier nicht harmonischer aber synchronisierter Taktsignale $C_1$ und $C_2$ aufweist, wobei die Taktsignale Perioden von Zeiteinheiten $T_1$ und $T_2$ aufweisen, die ein rationales Zahlenverhältnis

$$S = \frac{T_2/\alpha}{T_1/\alpha}$$

bilden, so daß die Beziehung zwischen den Taktimpulsfolgen sich alle $N_1 = T_2/\alpha$ Impulse von $C_1$ oder alle $N_2 = T_1/\alpha$ Impulse von $C_2$ wiederholt, was zu

$$\alpha = T_2/N_1 = T_1/N_2$$

führt, wobei die Datenübertragung unter der Steuerung des Taktsignales $C_1$ und eines Taktsignales $C_2'$ erfolgt, wobei jedes Taktsignal $C_1$ und $C_2'$ ebenfalls an das jeweilige System geliefert wird, wobei die Ausrichtung der kritischen Taktimpulsflanken der Taktsignale $C_1$ und $C_2$ für alle Kombinationen von Impulspaaren durch Verzögerung des Taktsignales $C_2$ um einen Betrag von $\alpha/2$ Zeiteinheiten zur Bildung des Taktsignales $C_2'$ vermieden wird, und wobei die Datenübertragung derart ausgeführt wird, daß für jede Richtung des Datenflußes über das Interface durch ein System gelieferte Daten zuerst durch den an dieses System gelieferten Takt abgetastet und dann durch den an das andere System gelieferten Takt abgetastet werden.

2. Einrichtung nach Anspruch 1, bei der der Taktgenerator einen ersten Oszillator (56) und einen zweiten spannungsgesteuerten Oszillator (50) aufweist, die jeweils mit einer Frequenz $f_1 = 1/T_1$ und $f_2 = 1/T_2$ arbeiten, wobei der zweite Oszillator durch den Schaltkreis einer Phasenregelschleife (Fig. 6) mit dem ersten Oszillator synchonisiert wird.

3. Einrichtung nach Anspruch 2, bei der der Taktgenerator durch einen mit dem Ausgang des zweiten Oszillators verbundenen Verzögerungsschaltkreis (D, Fig. 5) verschoben wird.

4. Einrichtung nach einem der vorhergehenden Ansprüche, bei der ein Paar von bistabilen Kippgliedern (38, 40; 34, 36) für jede Richtung des Datenflußes über das Interface vorgesehen ist, wobei jedes bistabile Kippglied eines Paares einen entsprechenden Takt der Takte $C_1$, $C_2'$ empfängt.

# FIG. 1
## PRIOR ART

# FIG. 2

1ST HARM    S    FUND

T2
ACCEPTABLE
RANGE

24

REGION
OF
INTEREST

0          12          24

T1 ACCEPTABLE RANGE

1

## FIG. 3

## FIG. 6

FIG. 4a

FIG. 4b

FIG. 4C

FIG. 5